Europäisches Patentamt

European Patent Office

Office européen des brevets

(11) Publication number: **0 405 330 A2**

# EUROPEAN PATENT APPLICATION

(21) Application number: **90111747.3**

(51) Int. Cl.⁵: **H01L 23/495**

(22) Date of filing: **21.06.90**

(30) Priority: **29.06.89 US 373128**

(43) Date of publication of application:
**02.01.91 Bulletin 91/01**

(84) Designated Contracting States:
**DE FR GB IT**

(71) Applicant: **MOTOROLA, INC.**
**1303 East Algonquin Road**
**Schaumburg, IL 60196(US)**

(72) Inventor: **Olson, Timothy Lee**
**11320 W Willow Lane**
**Phoenix, Arizona 85039(US)**

(74) Representative: **Ibbotson, Harold et al**
**MOTOROLA European Intellectual Property**
**Operations Jays Close Viables Ind. Estate**
**Basingstoke Hants RG22 4PD(GB)**

(54) Flagless leadframe, package and method.

(57) A flagless leadframe (10), package (12) and method is disclosed and a preferred embodiment includes a semiconductor die (16) bonded to the plurality of leads (14) of the flagless leadframe (10) by an electrically insulating film (18) that is disposed on the backside of the semiconductor die (16) while still in wafer form. The semiconductor die (16) is bonded to the flagless leadframe (10) so that at least 50 percent of the surface area of the backside of the semiconductor die (16) is thermally coupled to the plurality of leads (14) so that heat dissipates directly from the backside of the semiconductor die (16), through the electrically insulating film (18) and out of the package through the leads (14). The semiconductor die (16) is wirebonded directly to the plurality of leads (14) so that the same leads (14) are both thermally and electrically coupled to the semiconductor die (16).

FIG. 1

## FLAGLESS LEADFRAME, PACKAGE AND METHOD

### Background of the Invention

This invention relates, in general, to semiconductor device packaging and more particularly to flagless leadframe, package and method wherein thermal dissipation is greatly enhanced.

It is well known in the art that a limiting factor in the development of higher density, faster running integrated circuits is the heat dissipating capability of encapsulated devices. Typically, heat does not readily dissipate through a plastic encapsulant. Thermal dissipation has been improved in encapsulated packages by the addition of metal slabs such as heat spreaders to the package. Although the added metal improves the heat dissipation of the device, it also creates additional stress and cracks in the encapsulation thereby causing quality defects in the package in terms of obtaining good assembly yields and in withstanding various reliability requirements such as solder immersion and vapor phase exposure.

U. S. Patent 4,740,868 entitled "Rail Bonded Multi-Chip Leadframe, Method and Package" issued to Hawkins on April 26, 1988 teaches a leadframe having a plurality of rails on which a plurality of semiconductor chips may be mounted to form a multi-chip package. The semiconductor chips are electrically connected to the rails by wirebonds and further, the plurality of rails function as a heatsink.

Two papers by Ohno et al. one entitled "Characteristics of ASIC General-Purpose Leadframe" Denshi Zairyo, April, 1988, pages 85-90 and one entitled "Development of ASIC General-Purpose Leadframe with Variable Die Pad" Denshi Joho Tsushin Gakkai, October 27, 1987, SDM 87-106, ICD 87-64 disclose a general-purpose leadframe for ASIC applications. An insulating die pad tape is disposed on the inner lead of the leadframe and an IC/LSI chip is disposed on the die pad tape. In addition to adhering the chip to the leadframe, the die pad tape holds the inner lead stationery. The size of the die pad tape may be varied depending upon the size of the chip that is employed. However, nothing is mentioned about maximizing the portion of the inner lead which thermally contacts the die so that maximum heat dissipation may be obtained.

Accordingly, it would be highly desirable to provide a leadframe that maximizes thermal dissipation by maximizing the thermal contact between the leadframe and semiconductor die without employing a large slab of metal.

### Summary of the Invention

Accordingly, it is an object of the present invention to provide a flagless leadframe, package and method that allows for improved thermal dissipation.

Another object of this invention is to provide a flagless leadframe, package and method wherein a single leadframe size and configuration may be employed with semiconductor dice of varying size.

Yet a further object of the present invention is to provide a flagless leadframe, package and method that allows for increased assembly yields.

Yet another object of the present invention is to provide a flagless leadframe, package and method wherein the final device can withstand reliability requirements such as solder immersion and vapor phase exposure.

The foregoing and other objects and advantages are achieved in the present invention by one embodiment in which, as a part thereof, employs a flagless leadframe having a plurality of leads and a semiconductor die bonded thereto so that at least 50 percent of the surface area of the backside of the semiconductor die is thermally coupled to the plurality of leads. Further, the semiconductor die is wirebonded to some or all of the plurality of leads so that they are both thermally and electrically coupled to the die. An encapsulation is disposed about the semiconductor die and the leadframe so that a portion of the plurality of leads extends therefrom.

A more complete understanding of the present invention can be attained by considering the following detailed description in conjunction with the accompanying drawings.

### Brief Description of the Drawings

FIG. 1 is a highly enlarged top view of a flagless leadframe; and

FIG. 2 is a highly enlarged cross-sectional view of a semiconductor device package employing the leadframe of FIG 1.

### Detailed Description of the Invention

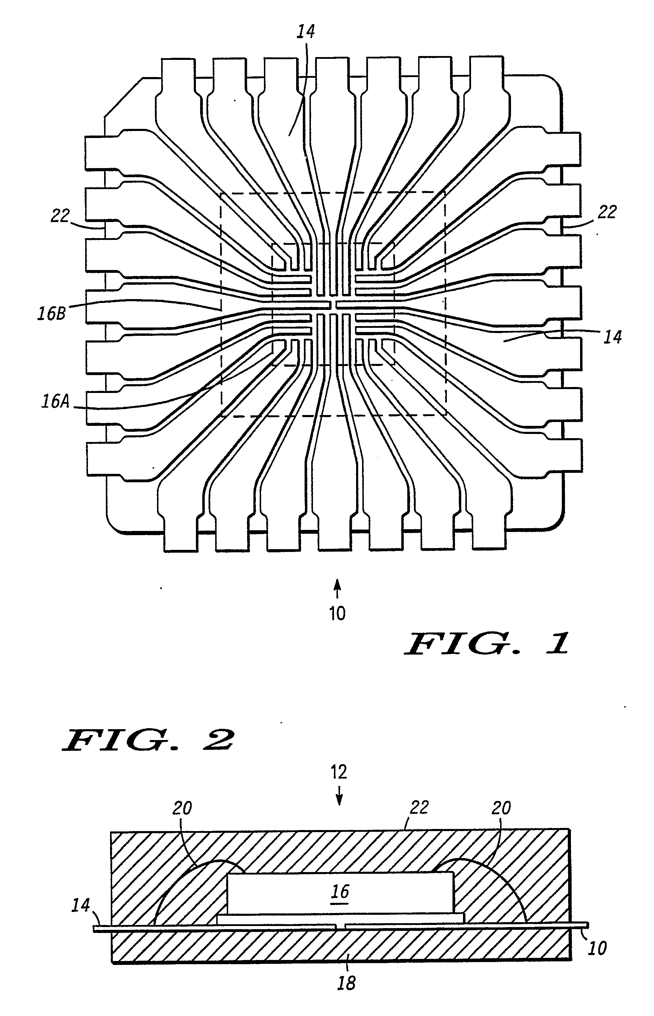

FIG. 1 is a highly enlarged top-view of a flagless leadframe 10 and FIG. 2 is a highly enlarged cross-sectional view of a semiconductor device package 12 employing leadframe 10 of FIG. 1.

Leadframe 10 includes a plurality of leads 14. A semiconductor die 16 (outlined in FIG. 1) is bonded to plurality of leads 14 of leadframe 10 by an electrically insulating film 18. Although other films may be used, preferred electrically insulating films 18 are polyimides and epoxies. One of skill in the art will understand that it is important that film 18 be electrically insulating so that the backside of semiconductor die 16 does not electrically contact plurality of leads 14 and cause a short. Electrically insulating film 18 must also be a good thermal conductor so that heat may be transferred to plurality of leads 14 from semiconductor die 16 and out of semiconductor device package 12. It is desirable that electrically insulating film 18 be as thin as possible so that thermal resistance is minimal. A preferred embodiment includes electrically insulating film 18 being disposed on the backside of semiconductor die 16 while still in wafer form although one of skill in the art will understand that electrically insulating film 18 may be formed on plurality of leads 14 of leadframe 10 and semiconductor die 16 may then be bonded thereon. Electrically insulating film 18 also serves to hold plurality of leads 14 of leadframe 10 in place until the device is encapsulated.

It is important that semiconductor die 16 be attached to plurality of leads 14 of leadframe 10 so that at least 50 percent of the surface area of the backside of semiconductor die 16 is thermally coupled to plurality of leads 14. In a preferred embodiment, at least 70 percent of the surface area of the backside of semiconductor die 16 will be thermally coupled to plurality of leads 14. It should be understood that not all members of plurality of leads 14 need to be thermally coupled to the backside of semiconductor die 16 for at least 50 percent surface coverage. In fact, not all members of plurality of leads 14 need to extend beneath semiconductor die 16.

Because such a large portion of the surface area of the backside of semiconductor die 16 is thermally contacted, the majority of heat will dissipate directly from the backside of the die through electrically insulating film 18, to plurality of leads 14 and then out of semiconductor device package 12 via plurality of leads 14. Additionally, because so much of the surface area of the backside of semiconductor die 16 is thermally contacted, heat will dissipate uniformly from semiconductor die 16 so that no hot spots (areas where heat is retained) develop on semiconductor die 16.

It should be understood that leadframe 10 as disclosed herein will constitute the principal heat flow path from a semiconductor package employing it. The reliance on thermal conduction through a plastic encapsulant that is prevalent in packages with conventional leadframes is substantially reduced. However, leadframe 10 also improves the secondary heat flow path which is through the bulk plastic and removal of heat occurs at the plastic surface and is substantially by convection and radiation. The relatively large metal/plastic ratio effectively and uniformly spreads heat throughout a plastic encapsulation.

The present invention also eliminates the need for leadframe variability. A single leadframe size and configuration may be employed with semiconductor dice of varying size. This is shown in FIG. 1 by outlines 16A and 16B of semiconductor dice of differing sizes. Additionally, it is possible to mount a plurality of semiconductor dice 16 on the same or oppositely facing surfaces of leadframe 10.

Once semiconductor die 16 has been mounted on plurality of leads 14 of leadframe 10 using electrically insulating film 18, it is then electrically connected to plurality of leads 14 through a wirebonding process. Wirebonds 20 extend from the contacts of semiconductor die 16 directly to various members of plurality of leads 14. This configuration allows some or all of plurality of leads 14 to be both thermally and electrically coupled to semiconductor die 16. Again, thermal connection occurs from the backside of semiconductor die 16 to plurality of leads 14 while electrical connection occurs to all or some of plurality of leads 14 via wirebonds 20.

Once the wirebonding has occurred, the device is encapsulated by an encapsulation 22, commonly of plastic. As is well known in the art, plastic encapsulation is disposed around semiconductor die 16 and leadframe 10 so that only portions of plurality of leads 14 extend therefrom. Leadframe 10 couples to a plastic encapsulation very well because the encapsulation may form between the members of plurality of leads 14 as opposed to an encapsulation forming around the flag of a typical leadframe. Further, encapsulation 22 holds plurality of leads 14 in place so that they do not touch each other thereby causing shorts during device operation.

Thus it is apparent that there has been provided, in accordance with the invention, a flagless leadframe, package and method which meet the objects and advantages set forth above. While specific embodiments of the present invention have been shown and described, further modifications and improvements will occur to those skilled in the art. It is desired that it be understood, therefore, that this invention is not limited to the particular forms shown and it is intended in the appended claims to cover all modifications which do not depart from the spirit and scope of this invention.

**Claims**

1. A flagless leadframe (10) being characterized by a plurality of leads (14) wherein a semiconductor die (16) is to be attached to said plurality of leads (14) so that at least fifty percent of the surface area of the backside of said semiconductor die (16) is thermally coupled to said plurality of leads (14) and further, some or all of said plurality of leads (14) to be both thermally and electrically coupled to said semiconductor die (16).

2. The leadframe (10) of claim 1 wherein an electrically insulating material (18) is to be disposed between the plurality of leads (14) of said leadframe (10) and the semiconductor die (16) to be disposed thereon.

3. The leadframe (10) of claim 2 wherein the electrically insulating material (18) bonds the semiconductor die (16) to the plurality of leads (14) of said leadframe (10).

4. The leadframe (10) of claim 3 wherein the electrically insulating material (18) is disposed on the backside of the semiconductor die (16) while still in wafer form.

5. The leadframe (10) of claim 4 wherein the electrically insulating material (18) comprises a polyimide or an epoxy.

6. The leadframe (10) of claim 1 wherein a single leadframe size and configuration may be employed with semiconductor dice (16) of varying size.

7. A semiconductor device package (12) comprising:
a flagless leadframe (10) having a plurality of leads (14); the invention being characterized by:
a semiconductor die (16) bonded to said plurality of leads (14) so that at least fifty percent of the surface area of the backside of said semiconductor die (16) is thermally coupled to said plurality of leads (14) and further, some or all of said plurality of leads being both thermally and electrically coupled to said semiconductor die (16); and
an encapsulation (22) disposed about said semiconductor die (16) and said leadframe (10) wherein a portion of said plurality of leads (14) extend therefrom.

8. The semiconductor device package (12) of claim 7 wherein the semiconductor die (16) is bonded to the plurality of leads (14) of the leadframe (10) with an electrically insulating material (18).

9. The semiconductor device package (12) of claim 7 wherein a single leadframe size and configuration may be employed with semiconductor dice (16) of varying size.

10. A method of fabricating a semiconductor device package (12) comprising the steps of:
providing a flagless leadframe (10) having a plurality of leads (14); the invention being characterized by:
bonding a semiconductor die (16) to said plurality of leads (14) of said leadframe (10) so that at least fifty percent of the surface area of the backside of said semiconductor die (16) is thermally coupled to said plurality of leads (14);
electrically connecting said semiconductor die (16) to said plurality of leads (14) of said leadframe (10); and
encapsulating said semiconductor die (16) and said leadframe (10) so that a portion of said plurality of leads (14) extends from the encapsulation (22).

*14*

*22* *22*

*16B*

*16A* *14*

*10*

# FIG. 1

# FIG. 2

*12*

*20* *22* *20*

*16*

*14* *10*

*18*